# EUROPÄISCHE PATENTSCHRIFT

(11) **EP 3 832 817 B1**
(45) Veröffentlichungstag und Bekanntmachung des Hinweises auf die Patenterteilung: **23.07.2025**
(21) Anmeldenummer: 19213058.1
(22) Anmeldetag: 03.12.2019
(51) Int. Cl.: H01S 5/12, H01S 5/22, H01S 5/32, H01S 5/026, H01S 5/20, H01S 5/40

(54) **HALBLEITERLASER SOWIE VERFAHREN ZUR HERSTELLUNG EINES HALBLEITERLASERS**
SEMICONDUCTOR LASER AND METHOD FOR PRODUCING THE SAME
LASER SEMI-CONDUCTEUR AINSI QUE PROCÉDÉ DE FABRICATION D'UN LASER SEMI-CONDUCTEUR

(43) Veröffentlichungstag der Anmeldung: 09.06.2021
(73) Patentinhaber: Advanced Photonics Applications GmbH, 97218 Gerbrunn (DE)
(72) Erfinder: KOETH, Johannes, 97218 Gerbrunn (DE); KOSLOWSKI, Tim, 97199 Ochsenfurt (DE); KOSLOWSKI, Nicolas, 97070 Würzburg (DE)
(74) Vertreter: advotec.

(56) Entgegenhaltungen:
- US-A1- 2005 129 084
- US-A1- 2010 158 063
- US-A1- 2012 093 187
- YANG CHENG-AO ET AL: "High-power, high-spectral-purity GaSb-based laterally coupled distributed feedback lasers with metal gratings emitting at 2 [mu]m", APPLIED PHYSICS LETTERS, A I P PUBLISHING LLC, US, vol. 114, no. 2, 15 January 2019 (2019-01-15), XP012234634, ISSN: 0003-6951, [retrieved on 20190115], DOI: 10.1063/1.5080266
- WANG Y B ET AL: "Coupling coefficient calculation for GaSb-based quantum well distributed feedback lasers with laterally coupled gratings;Coupling coefficient calculation for GaSb-based quantum well distributed feedback lasers with laterally coupled gratings", JOURNAL OF PHYSICS D: APPLIED PHYSICS, INSTITUTE OF PHYSICS PUBLISHING, BRISTOL, GB, vol. 45, no. 50, 20 November 2012 (2012-11-20), pages 505109, XP020233296, ISSN: 0022-3727, DOI: 10.1088/0022-3727/45/50/505109

## Beschreibung

### Technisches Gebiet der Erfindung:

Die vorliegende Erfindung betrifft ein Verfahren zur Herstellung eines Halbleiterlasers, insbesondere einer Halbleiterlaserdiode, nach dem Anspruch 1. Ferner betrifft die vorliegende Erfindung einen Halbleiterlaser, insbesondere eine Halbleiterlaserdiode, gemäß dem Anspruch 8, welcher eine monomodige Halbleiterlaserdiode umfassend ein Halbleitersubstrat mit darauf angeordneter Materialschichtfolge oder Mehrschichtstruktur betrifft, mit einer darin angeordneten Laserschicht oder aktiven Region und mindestens einem darüber angeordneten Wellenleitersteg sowie mit seitlich zum Wellenleitersteg, bzw. ggf. den Wellenleiterstegen, angeordneten Materialabtragsbereichen, in denen ein Teil der Mehrschichtstruktur oder Materialschichtfolge entfernt wurde.

### Stand der Technik:

Halbleiterlaserdioden, oder etwas allgemeiner Halbleiterlaser, stellen gemäß dem Stand der Technik eine bekannte Quelle zur Erzeugung kohärenter elektromagnetischer Strahlung dar und werden für eine Vielzahl unterschiedlicher Anwendungen eingesetzt. Typische Anwendungsgebiete von Halbleiterlaserdioden sind die Datenübertragung in der Telekommunikation oder Analyse und Sensorik. Viele dieser Anwendungen setzen eine monomodige kohärente Strahlungsquelle mit durch die Anwendung festgelegter Wellenlänge voraus und stellen darüber hinaus noch weitere für die jeweilige Anwendung spezifische Anforderungen. Diese Anforderungen sind zum Beispiel ein bestimmter Abstimmbereich der Wellenlänge des Lichtes, z.B. um spektrale Eigenschaften eines Stoffes messen zu können, eine genau vorgegebene Ausgangsleistung, ein vorgegebenes Fernfeldprofil, oder eine besonders hohe Seitenmodenunterdrückung.

Nachfolgend soll überwiegend der Begriff der Halbleiterlaserdiode verwendet werden, wobei jedoch alle Halbleiterlaser unter diesen Begriff fallen sollen, die streng genommen keine Diode oder Diodenstruktur ausbilden.

Halbleiterlaserdioden basieren auf dem Prinzip der stimulierten Emission, wonach eine Lichtmode exponentiell verstärkt wird, wenn sie im Verstärkungsspektrum des Lasermediums liegt und gleichzeitig ihre Verluste, insbesondere die Spiegelverluste, minimiert werden. Ohne eine weitere Beeinflussung gibt es in dem angeregten oder erzeugten Lichtspektrum viele sog. Fabry-Perot-Moden, d.h. Lichtmoden mit minimalen Spiegelverlusten, im Verstärkungsprofil des Lasermediums, so dass die Laserdiode ein breites Spektrum an Moden emittiert.

Um eine Selektion aus dieser Vielzahl von Moden vorzunehmen, offenbart beispielsweise die EP 0 984 535 B1 eine Halbleiterlaserdiode mit einem Wellenleitersteg und ein parallel zum Wellenleitersteg angeordnetes periodisches Gitter. Die Gitterperiode, d.h. die Abstände vom Beginn eines Gittersteges bis zum Beginn des nächsten Gittersteges, wird als die halbe Wellenlänge der gewünschten Lasermode im Wellenleitermedium eingestellt. Das Gittermaterial wird so gewählt, dass es einen von seiner Umgebung unterschiedlichen Brechungsindex und Absorptionskoeffizienten besitzt, um so eine periodische Modulation des effektiven komplexen Brechungsindex für Moden im Wellenleiter einzustellen. Die periodische Modulation des Brechungsindex führt zu einer starken Wellenlängenabhängigkeit der Spiegelverluste, wogegen die periodische Modulation des Absorptionskoeffizienten zu zusätzlichen Verlusten mit starker Wellenlängenabhängigkeit führt. Mit diesem Mechanismus lässt sich ein monomodiger Betrieb der Laserdiode auf der durch das Gitter eingestellten Wellenlänge erreichen.

Die bekannten Halbleiterlaserdioden mit periodischem lateralem Gitter besitzen jedoch den Nachteil, dass ein aus periodisch angeordneten Stegen bestehendes Gitter andere Eigenschaften des Halbleiterlasers nicht verbessert oder sogar verschlechtert. Dies betrifft insbesondere weitere Eigenschaften der Lasermode, die gezielte Beeinflussung der Verspannung des Halbleitermaterials sowie die optimierte Beeinflussung der thermischen Eigenschaften der Laserdiode. Die bekannten Laserdioden besitzen daher Eigenschaften, die im Rahmen der Herstellung nicht oder nur ungenügend beeinflusst und/oder reproduziert werden können. Dies bedeutet auch, dass im Rahmen der Herstellung mitunter viel Ausschuss entsteht, da durch die mangelnde oder zumindest nicht reproduzierbare Beeinflussbarkeit von optischen, thermischen und/oder mechanischen Eigenschaften ansonsten funktionsfähige Halbleiterlaser nicht dem gewünschten Anforderungspotential oder den geforderten Charakteristika entsprechen.

So hat z.B. die durch das Gitter der bekannten Laserdioden erzeugte Verspannung des Lasermaterials einen starken Einfluss auf das Verstärkungsspektrum, die Detailstruktur des Gitters in der Nähe der Facette der Laserdiode einen Einfluss auf dessen Fernfeld und die weiter vom Wellenleiter entfernt gelegene Strukturierung einen Einfluss auf die Lateralmoden, wobei diese Einflüsse bisher nicht kompensierbar und teilweise nicht einstellbar waren, so dass die Monomodigkeit der bekannten Halbleiterlaser mit Gitterstruktur mit einem teilweise hohen Preis erkauft wurde, der zu Lasten der sonstigen Eigenschaften des Halbleiterlasers erreicht wurde.

Ein Halbleiterlaser mit einem Stegwellenleiter und lateralen Gittern zur Modenselektion ist z.B. aus C.-A. Yang et al., Appl. Phys. Lett. 114 (2019) 021102 bekannt.

Vor diesem Hintergrund ist es die Aufgabe der vorliegenden Erfindung, eine Verbesserung der oben beschriebenen Halbleiterlaserdioden und des dabei eingesetzten Herstellungsverfahrens vorzuschlagen, mit denen neben einer bekannten monomodalen Strahlung weitere optische, thermische und mechanische Eigenschaften des Halbleiterlasers gezielt eingestellt werden können, ohne dass dabei im Hinblick auf die Verfahrensschritte des Herstellungsverfahrens ein deutlicher Mehraufwand in Kauf genommen werden muss.

Diese Aufgabe wird mit einem Verfahren zur Herstellung eines Halbleiterlasers mit den Merkmalen des Anspruchs 1 bzw. durch einen Halbleiterlaser mit den Merkmalen des Anspruchs 8 gelöst. Vorteilhafte Ausführungsformen sind Gegenstand der Unteransprüche.

Das erfindungsgemäße Verfahren nach Anspruch 1 sieht im Einzelnen vor, dass in an sich bekannter Weise das Aufbringen einer Mehrschichtstruktur oder Materialschichtfolge auf einem Substrat, insbesondere einem Halbleitersubstrat, erfolgt, wobei die Schichten der Mehrschichtstruktur parallel zu einer durch eine Oberfläche des Substrats definierten Schichtausbreitungsebene verlaufen und wobei das Aufbringen der Mehrschichtstruktur zumindest das Erzeugen einer aktiven Region oder Laserschicht umfasst. Weiter umfasst das Verfahren den bekannten Verfahrensschritt des Abtragens von Material der Mehrschichtstruktur in zumindest zwei voneinander getrennten Materialabtragsbereichen, wobei der Materialabtrag im Wesentlichen senkrecht zur Schichtausbreitungsebene erfolgt und dadurch ein Wellenleitersteg gebildet wird. Es kann jedoch auch vorgesehen sein, dass der Wellenleitersteg trapezförmig ausgebildet ist, mit Flanken, die dann nicht rechtwinklig, sondern schräg zur Schichtausbreitungsebene verlaufen.

In einem weiteren, an sich bekannten Verfahrensschritt erfolgt anschließend die Erzeugung von einer Isolationsschicht auf zumindest den Materialabtragsbereichen.

Erfindungsgemäß ist jedoch vorgesehen, dass in einem weiteren Verfahrensschritt, der nicht zwangsläufig während der Herstellung an sich ablaufen muss, sondern der auch schon im Vorfeld zu der tatsächlichen Herstellung der Halbleiterlaserdiode durchgeführt werden kann, das Bestimmen einer zweidimensionalen binärwertigen, diskreten Lateralstruktur in einem Optimierungsverfahren unter Berücksichtigung zumindest der gewünschten Eigenschaften der dreidimensionalen Lasermode, insbesondere der Wellenlänge, erfolgt, wobei im Rahmen des Optimierungsverfahrens die Bereiche, in denen die Lateralstrukturschicht aufbringbar ist, in ein regelmäßiges Gitter unterteilt werden, und zur Beschreibung der Lateralstruktur eine die Gitterzellen betreffende zweidimensionale, bevorzugt diskrete und/oder binäre, Startfunktion optimiert wird. Dies bedeutet, dass die Fläche oder Oberfläche des in der Herstellung befindlichen Halbleiterlaserbauteils, die zur Anordnung einer Lateralstrukturschicht zur Verfügung steht, zunächst ohne tatsächliche Einwirkung oder Beeinflussung des Bauteils selbst, beispielsweise im Rahmen einer Simulation oder Vorausberechnung, in eine Vielzahl von Gitterzellen unterteilt wird und dann unter Definition der sonstigen Eigenschaften des Halbleiterlasers und unter Definition von gewünschten Eigenschaften des Halbleiterlasers die Gitterzellen im Optimierungsverfahren "gefüllt" oder "belegt" werden, um dadurch das jeweils entstehende Muster der gefüllten Gitterzellen und die dadurch stattfindende Wechselwirkung der simulierten Lateralstrukturschicht mit dem Halbleiterlaser zu prüfen und zu optimieren. Die Lateralstruktur weist dabei eine zweidimensionale diskrete Struktur auf und nimmt binäre Werte an. Auch die Startfunktion kann bereits eine entsprechende Strukturierung und Binärwerte aufweisen. Es können jedoch auch andere Startfunktionen gewählt werden, die dann ggf. zu Beginn oder zum Abschluss der Optimierung in zweidimensionale, diskrete und binäre Werte überführt werden.

Nach Abschluss des Optimierungsverfahrens wird dann die vorab in der Simulation und/oder Optimierung ermittelte oder vorab definierte Lateralstruktur erzeugt und in Form einer Lateralstrukturschicht ausgebildet oder abgeschieden. In einem weiteren Verfahrensschritt wird also das Aufbringen von einer Lateralstrukturschicht durchgeführt, wobei das Material, aus dem die Lateralstrukturschicht gebildet wird, einen vom umgebenden Halbleitermaterial unterschiedlichen Brechungsindex aufweist. Die Lateralstrukturschicht wird zumindest im Bereich der Materialabtragsbereiche erzeugt, wobei die Strukturen in einem Maskierungs- und Abscheidungsprozess anhand der optimierten Lateralstruktur ausgebildet werden. Von den Verfahrensschritten unterscheidet sich daher die Aufbringung der Lateralstrukturschicht nicht von einer bekannten Gitterstrukturschicht. Jedoch im Hinblick auf die erzeugte Struktur und deren Wechselwirkungen mit der Halbleiterlaserdiode unterscheidet sich die Lateralstrukturschicht sehr deutlich von den bekannten regelmäßigen Gittern. Die Lateralstrukturschicht ist im Gegensatz zum bekannten regelmäßigen Gitter "echt" zweidimensional. Dies bedeutet, dass mit zunehmendem Abstand vom Wellenleitersteg nicht nur ein und das selbe Muster - bevorzugt Gitterbalken - wiederholt wird, sondern jede parallel zum Wellenleitersteg verlaufende Zeile oder Spalte der Lateralstrukturschicht potentiell eine individuelle Anordnung binärer Werte widerspiegelt und entsprechend zweidimensional individuelle Strukturen der Lateralstrukturschicht ermöglichen kann.

Der Grundgedanke der Erfindung kann also auch darin gesehen werden, anstatt einer Anordnung einer sehr groben und nur in einer Richtung, entlang des Wellenleiterstegs, strukturierten Geometrie des bekannten Gitters eine sehr viel feinere und darüber hinaus zweidimensionale Strukturierung vorzunehmen, um sowohl eine Einstellbarkeit von optischen Eigenschaften als auch eine Einstellbarkeit von anderen Eigenschaften des Halbleiterlasers zu erreichen.

Mit anderen Worten ausgedrückt ermöglicht das Verfahren eine Halbleiterlaserdiode, welche einerseits eine monomodige kohärente Strahlungsquelle erzeugt und gleichzeitig eine gezielte erwünschte Einstellung der Verspannung des Lasermaterials sowie eine gezielte Einstellung des Überlapps der Lateralstruktur mit der Lasermode in der Nähe der Facette der Laserdiode und eine gezielte Einstellung des Überlapps der Lateralstruktur mit lateralen Moden erlaubt. Dies wird durch eine an die Anforderungen angepasste Lateralstrukturschicht seitlich des Wellenleiters der Laserdiode erreicht. Diese Lateralstrukturschicht besteht aus der gezielten Modifikation des Brechungsindex seitlich des Wellenleiters gemäß einer vorgegebenen binärwertigen Funktion f(x,y), wobei beispielsweise x die Koordinate parallel zu der Laserfacette (gemessen von der linken Kante des ersten Wellenleitersteges) und y die Koordinate parallel zu den Wellenleiterstegen (gemessen von der bevorzugten Laserfacette) darstellt. Diese gezielte Modifikation des Brechungsindex kann sowohl durch Aufbringen eines Materials mit vom Halbleiter unterschiedlichem komplexem Brechungsindex als auch durch Abtragen von Material an den Punkten erfolgen, an denen die vorgegebene Funktion f(x,y) den Wert 1 annimmt.

Der Brechungsindexkontrast, der durch Auswahl des Materials vorgenommen wird, und die vorgegebene Funktion werden darauf optimiert, um die an die Laserdiode gestellten Anwendungsanforderungen optimal zu erfüllen.

Die Zielwellenlänge wird durch Strukturierung der ersten 500 nm neben dem Wellenleitersteg eingestellt, durch Strukturierung des nächsten Bereichs wird die Verspannung in der Laserschicht eingestellt, wobei der nächste Bereich die nächsten 1 µm sein kann, und durch die weiter vom Wellenleitersteg entfernt liegende Struktur gezielt unerwünschte Lateralmoden unterdrückt. Zudem kann ein nachteiliger Effekt der Lateralstruktur auf das Fernfeld durch eine gezielte Verringerung der Strukturierung in der Nähe der Emissionsfacette minimiert werden.

Im Hinblick auf das Optimierungsverfahren kommen grundsätzlich unterschiedliche Verfahren in Frage, die in der Lage sind, eine große Anzahl von möglichen Kombinationen zu erfassen, zu vergleichen und zu analysieren. Beispielhaft sei nachfolgend ein Optimierungsverfahren in Form eines genetischen Algorithmus beschrieben:
Die Lateralstrukturschicht wird mit dem Ziel, die technischen Anforderungen an den Laser besonders gut zu erfüllen, optimiert. Beispielweise kann davon ausgegangen werden, dass diese technischen Vorgaben die Wellenlänge, das Seitenmodenunterdrückungsverhältnis, thermische und mechanische Stabilitätseigenschaften sowie die Form des Fernfeldes des Lasers beinhalten. Hierzu wird nun eine Epitaxie oder Mehrschichtstruktur ausgesucht, die für einen Laser mit diesen Eigenschaften geeignet ist.

In der Praxis kann man annehmen, dass die für den Laser mit vorgegebener Geometrie wichtigen Eigenschaften dieser Epitaxie in vorbereitenden Experimenten gemessen sind, so dass man ein Computermodell für die Epitaxie anlegen kann, mit dem man die erwarteten Eigenschaften des Lasers für eine vorgegebene Lateralstrukturschicht vorhersagen kann.

Man kann dieses Computermodell zum Beispiel dazu nutzen, mit Hilfe eines genetischen Algorithmus eine optimierte Lateralstruktur zu erzeugen. Dazu erzeugt man eine Startpopulation von Lateralstrukturen, welche auf Erfahrungswerten von bereits bekannten Lasern basieren, mit näherungsweisen Eigenschaften und einer gezielten Streuung. Diese Startpopulation kann beispielsweise eine Anzahl von gewissen Variationen einer Startfunktion darstellen. Das Erbgut der Individuen oder Lateralstrukturen sind die diskreten binärwertigen Funktionen f(x,y), die die Lateralstruktur definieren. Dies bedeutet, der genetische Algorithmus wird dazu verwendet, diese binärwertige Funktion zu optimieren. Dazu definiert man eine Fitnessfunktion, die durch das Computermodell vorhergesagte Lasereigenschaften höher bewertet, wenn diese die Spezifikationen besser erfüllen. Man kann nun eine existierende Implementation eines genetischen Algorithmus verwenden, um die binärwertige Funktion zu optimieren. Die erfolgversprechenden Lateralstrukturen, die durch dieses Optimierungsverfahren hervorgebracht werden, können dann experimentell realisiert werden und charakterisiert werden, um die theoretischen Vorhersagen zu überprüfen.

Gemäß einer vorteilhaften Ausgestaltung der Erfindung ist vorgesehen, dass die Startfunktion des Optimierungsverfahrens eine Reihe, bevorzugt zwei Reihen, von parallelen gleichmäßig beabstandeten Stegen darstellt, die insbesondere so angeordnet und ausgerichtet sind, dass bei einer Ausbildung der Lateralstrukturschicht gemäß der nicht optimierten Startfunktion der Lateralstruktur die Längserstreckung der parallelen Stege im Wesentlichen senkrecht zu der Längserstreckung des Wellenleiterstegs der Halbleiterdiode verlaufen würde. Dies bedeutet, dass die Optimierung der Startfunktion bevorzugt ihren Ausgangspunkt in einer klassischen Gitterstruktur eines DFB-Gitters (distributed feedback) haben kann. Aber auch andere Startfunktionen sind möglich.

In einer weiteren vorteilhaften Ausführungsform kann auch vorgesehen sein, dass das Optimierungsverfahren die Lateralstruktur in unterschiedlichen Abstandsbereichen vom Wellenleitersteg optimiert. Damit kann beispielsweise im Bereich angrenzend an den Wellenleitersteg und/oder im Überlapp zum Wellenleitersteg eine Optimierung der optischen Eigenschaften erfolgen, in einem weiter entfernten Bereich beispielsweise eine Optimierung der thermischen Eigenschaften und in einem am weitesten vom Wellenleitersteg entfernten Bereich eine Optimierung einer mechanischen Verspannung.

Ebenfalls kann vorgesehen sein, dass das Optimierungsverfahren die Lateralstruktur in den Bereichen, die bei einer Ausbildung der Lateralstrukturschicht angrenzend an die die Laserstrahlung auskoppelnden Facetten angeordnet werden, optimiert. Dadurch kann besonders vorteilhaft eine Beeinflussung des Fernfeldes erfolgen.

Es sei hierbei erwähnt, dass die vorab simulierte Optimierung der gesamten Lateralstruktur gegenüber einer üblichen sequenziellen experimentellen Optimierung mehrere Vorteile hat: (1) die Entwicklungszeit wird deutlich verkürzt, weil der Parameterbereich als Ganzes optimiert wird; (2) die Entwicklungskosten werden deutlich reduziert, da die Herstellung experimenteller Proben deutlich kostenintensiver ist als die Durchführung von Computersimulationen; (3) man kann Optimierungsverfahren verwenden, wie der im Beispiel verwendete genetische Algorithmus, die es erlauben, "unerwartete" Synergien zu finden, die ansonsten nicht einfach zu finden wären.

### Allgemeine Beschreibung des Herstellungsverfahrens:

Am Anfang des erfindungsgemäßen Verfahrens steht die Auswahl eines geeigneten Materialsystems, auf dem eine Materialschichtfolge aufgebracht wird.

Die auf dem Halbleitersubstrat angeordnete Materialschichtfolge ist vorteilhafterweise mittels eines einzigen und ununterbrochenen Epitaxieprozesses erzeugt und schichtweise auf dem Halbleitersubstrat angeordnet, wobei sich die jeweiligen Schichten parallel zur Schichtausbreitungsebene erstrecken, die durch die Oberfläche des Substrats oder Halbleitersubstrats definiert wird.

Im Rahmen der Erfindung bevorzugte Epitaxieprozesse sind z.B. die sog. Molekularstrahlepitaxie oder die sog. Gasphasenepitaxie.

Die mittels des Epitaxieprozesses erzeugte Materialschichtfolge umfasst dabei vorteilhaft alle zur Erzeugung der elektromagnetischen Welle mittels stimulierter Emission benötigten Schichtstrukturen, insbesondere eine aktive Zone oder Region und die sie umgebenden Schichten, wie beispielsweise eine obere Mantelschicht, eine obere Wellenleiterschicht, eine untere Wellenleiterschicht sowie eine untere Mantelschicht.

Weiterhin ist es bevorzugt vorgesehen, dass die aktive Zone oder Region als ein oder mehrere Quantenfilme ausgebildet ist. Ebenso bevorzugt kann die aktive Zone oder Region auch eine oder mehrere Schichten umfassen, die jeweils Quantenpunkte aufweisen.

Der Materialabtrag des Anteils der Materialschichtfolge oder Mehrschichtstruktur erfolgt bevorzugt durch einen bekannten physikalischen oder chemischen Ätzprozess.

Die Tiefe des Materialabtrags entspricht der Höhe des durch den Materialabtrag aus dem verbleibenden Rest der Materialschichtfolge erzeugten Wellenleiterstegs. Es ist dabei sowohl möglich und bevorzugt, den Ätzprozess oberhalb der aktiven Zone zu stoppen, insbesondere in der oberen Wellenleiterschicht, oder sogar oberhalb der oberen Wellenleiterschicht zu stoppen, als auch den Ätzprozess so weit fortzusetzen, dass die aktive Zone oder Region lateral zum Wellenleitersteg vollständig abgetragen wird und der Ätzprozess erst in einer tieferliegenden Schicht, beispielsweise der unteren Wellenleiterschicht, zum Erliegen kommt.

Die Ätztiefe kann bevorzugt über die Ätzdauer und die bekannte Reaktivität bzw. Ätzgeschwindigkeit des verwendeten Ätzprozesses bei Anwendung auf die jeweils vorliegende Materialschichtfolge gesteuert werden. Nach Ablauf der gewünschten Ätzdauer kann z.B. ein physikalischer Ätzprozess unterbrochen werden, indem keine weiteren Ionen auf die Materialschichtfolge mehr beschleunigt werden. Ebenso kann z.B. ein chemischer Ätzprozess unterbrochen werden, indem die verwendete Säure mittels eines Abspülmittels von der Materialschichtfolge abgespült wird.

Vor Durchführung des Ätzprozesses wird vorteilhaft ein Maskierungsprozess zur Aufbringung einer sog. Ätzmaske auf die Mehrschichtstruktur oder Materialschichtfolge durchgeführt, wobei die Ätzmaske gegenüber dem oder den jeweils verwendeten Ätzverfahren bevorzugt weitgehend oder insbesondere vollständig resistent ist. Daraus ergibt sich der Vorteil, dass die von der Ätzmaske abgedeckten bzw. maskierten Bereiche der Materialschichtfolge nicht geätzt werden. Durch Aufbringen einer Ätzmaske beispielsweise in der zweidimensionalen Oberflächengeometrie des Wellenleiterstegs kann somit der Wellenleitersteg präzise erzeugt werden. Anschließend kann die Ätzmaske wieder entfernt werden, z.B. durch ein geeignetes Lösemittel.

Bei der Ätzmaske kann es sich bevorzugt um eine metallische Ätzmaske handeln.

Um zu vermeiden, dass der Materialabtrag, insbesondere der Ätzprozess, unerwünscht tief in die Materialschichtfolge vordringt, kann die Halbleiterlaserdiode eine während des Epitaxieprozesses der Materialschichtfolge erzeugte sog. Ätzstoppschicht umfassen, welche gegenüber dem jeweils verwendeten Ätzprozess völlig resistent ist oder zumindest eine vergleichsweise hohe Resistenz aufweist. Diese Ätzstoppschicht bildet bevorzugt die Grundfläche, auf welcher beispielsweise der Wellenleitersteg angeordnet werden kann sowie auch lateral zum Wellenleitersteg die Lateralstruktur angeordnet werden kann.

Bevorzugt ist es vorgesehen, dass unmittelbar auf die mittels des Ätzprozesses frei geätzte Oberfläche in den abgetragenen Bereichen, beispielsweise die Ätzstoppschicht oder jede andere Schicht der Materialschichtfolge, bei welcher das Ätzverfahren gestoppt wird, zunächst eine vergleichsweise dünne Barriere- und/oder Isolationsschicht aufgebracht wird. Diese Barriere- und Isolationsschicht befindet sich zu beiden Seiten lateral des Wellenleiterstegs. Sie besteht vorzugsweise aus einem Oxid bzw. Nitrid, beispielsweise SiO₂ bzw. Si₃N₄, und ist vorzugsweise 5 nm bis 30 nm stark. Bei einer trapezförmigen Ausgestaltung des Wellenleiterstegs kann die Barriere- und/oder Isolationsschicht auch auf seitlichen Flanken des Wellenleiterstegs angeordnet werden.

Bevorzugt ist es vorgesehen, dass die Lateralstrukturschicht aus Chrom (Cr) oder einer Chrom enthaltenden Legierung besteht. Chrom ermöglicht aufgrund seines Brechungsindex und seines vergleichsweise hohen Absorptionskoeffizienten eine wirkungsvolle komplexe Kopplung mit der elektromagnetischen Welle in der Halbleiterlaserdiode, obwohl die Lateralstruktur seitlich neben dem Wellenleitersteg angeordnet ist und damit oberhalb bzw. unterhalb der aktiven Zone. Da im Betrieb der Halbleiterlaserdiode üblicherweise eine Strominjektion ausschließlich über den Rücken des Wellenleiterstegs erfolgt, wird die aktive Zone auch nur im Bereich unter dem Wellenleitersteg bestromt, so dass im Wesentlichen nur hier die stimulierte Emission erfolgt. Die Lateralstruktur kann somit nicht nur einen Höhenversatz zu demjenigen Bereich der aktiven Zone aufweisen, in welchem die stimulierte Emission erfolgt, sondern auch einen Seitenversatz. Es hat sich gezeigt, dass trotz dieser Beabstandung der Lateralstruktur von der bestromten aktiven Zone ein ausreichend großer Anteil der Lasermode bzw. der weiteren elektromagnetischen Wellen mit der Lateralstruktur räumlich überlappt, so dass aufgrund der besonderen Materialeigenschaften von Chrom bzw. der Chrom enthaltenden Legierung eine entsprechende Wechselwirkung in Form der komplexen Kopplung zwischen der Lateralstruktur und der Lasermode bzw. der weiteren elektromagnetischen Wellen stattfindet.

Die Stärke der Kopplung wird im Allgemeinen bestimmt über die Kopplungskonstante, welche proportional zum Produkt aus dem Füllfaktor der Lateralstruktur und der Absorption des Lateralstrukturmaterials ist.

Bevorzugt ist es vorgesehen, dass die Lateralstruktur nach Maßgabe der vorgebbaren Funktion bis an den Wellenleitersteg heranreicht und diesen insbesondere berührt, besonders bei nicht senkrecht verlaufenden Rändern des Wellenleiterstegs. Je näher die Lateralstruktur an den Wellenleitersteg heranreicht oder auch im Bereich des Wellenleiterstegs ausgebildet ist, desto größer wird der Überlapp mit der Lasermode bzw. den weiteren elektromagnetischen Wellen und dementsprechend stärker die Kopplung zwischen der Lasermode bzw. den weiteren elektromagnetischen Wellen und der Lateralstruktur.

Vorteilhafterweise wird die Lateralstrukturschicht mittels Verdampfen des metallischen Materials, insbesondere thermischem Verdampfen, Verdampfen durch Ionenbeschuss oder Verdampfen durch Elektronenbeschuss, auf die Halbleiterlaserdiode aufgebracht. Dem Aufbringen der Lateralstruktur geht bevorzugt ein entsprechender Maskierungsprozess und/oder Lithographieprozess voraus.

Alternativ bevorzugt kann die Lateralstruktur auch mittels eines Sputter-Prozesses auf die Halbleiterlaserdiode aufgebracht werden.

Gemäß einer bevorzugten Ausführungsform der Erfindung ist es vorgesehen, dass die Oberfläche, insbesondere in den Materialabtragsbereichen, in ein Raster mit einer vorgebbaren Anzahl von Rasterelementen unterteilt wird, wobei nach Maßgabe der binären Funktion f(x,y) jedem Rasterelement oder jeder Gitterzelle ein Gitterelement zuordenbar ist. Das bedeutet also, dass die Oberfläche in eine endliche Anzahl diskreter Rasterelemente oder Gitterzellen unterteilt wird und dass die diskrete binäre Funktion f(x,y) jedem Rasterelement nur entweder den Wert 0 oder den Wert 1 zuordnet. Bevorzugt kann die Grundfläche, auf welcher die Lateralstruktur als Lateralstrukturschicht ausgebildet wird, zwischen 10⁸ und 10¹⁰ Rasterelemente aufweisen. Bei einer Grundfläche der zu strukturierenden Fläche, bevorzugt in den Materialabtragsbereichen, von in der Regel weniger als 0,25 mm² ist somit trotz des Verwendens diskreter Rasterelemente oder Gitterzellen eine sehr feine Strukturierung möglich.

In diesem Zusammenhang sei erwähnt, dass die diskreten Eigenschaften der Lateralstruktur nach deren Ausbildung oder Erzeugung in Form der Lateralstrukturschicht nicht oder nur noch vernachlässigbar zutage treten oder erkennbar sind. Die Lateralstrukturschicht, insbesondere einzelne Strukturen der Lateralstrukturschicht, bildet/bilden also keine Pixelstruktur aus, sondern zusammenhängende Strukturen, deren Form und Größe aus den Rasterelementen gebildet sind. Das bedeutet, dass man zwei einzelne aneinander angrenzende gefüllte (Wert: 1) Rasterelemente der Lateralstrukturschicht nicht als solche erkennt, sondern als eine gemeinsame oder einheitliche Struktur, welche die Fläche von zwei Rasterelementen einnimmt oder ausfüllt. Dies ist den an sich bekannten Verfahren zur Erzeugung der Lateralstrukturschicht geschuldet, bei denen zusammenhängende Rasterelemente oder Gitterzellen gemeinsam mit dem Material der Lateralstrukturschicht beschichtet oder aufgefüllt werden, so dass die fertige Lateralstrukturschicht zwar an bestimmten Stellen, beispielsweise einem Rand einer größeren Struktur, bei einer geeigneten Vergrößerung noch die Raster- oder Gittereigenschaft erkennen lässt, im Inneren von derartigen Strukturen aber eine einheitliche homogene Schicht vorliegt.

In der vorliegenden Erfindung geht man zwar von einer diskreten binärwertigen Funktion zur Definition der Lateralstruktur aus. In Versuchsreihen der Anmelderin stellte sich heraus, dass die sich durch die Diskretisierung ergebenden, von der optimalen Struktur abweichenden Artefakte sich nicht nachteilhaft auf die Monomodigkeit der Halbleiterlaserdiode auswirken. Insbesondere wird durch Moden gemäß dem sog. Übergitter, das sich durch eine Fourier-Rücktransformation einer Vergröberung der Fouriertransformation der diskretisierten Lateralstruktur ergibt, die emittierte Mode bestimmt.

Gemäß der bevorzugten Ausführungsform der Erfindung ist es vorgesehen, dass die Funktion f(x,y) zusätzlich so gewählt oder optimiert wird, dass sie eine oder mehrere Eigenschaften der Halbleiterlaserdiode optimiert. Dadurch können Faktoren zur Beeinflussung der Lasermode, die im Stand der Technik bisher unberücksichtigt geblieben sind, nicht nur berücksichtigt werden, sondern vorteilhaft verwendet und/oder eingestellt werden. Dies wiederum ermöglicht ein gezielteres und wirkungsvolleres Beeinflussen von erwünschten bzw. unerwünschten Eigenschaften der Lasermode, wie etwa Verbesserungen der Monomodigkeit, der Verstärkung, der Temperaturstabilität bzw. des Schwellenstroms, deutlich über den bekannten Rahmen hinaus. Mit anderen Worten werden weitere Möglichkeiten zur Anpassung der Eigenschaften der Lasermode über den bekannten Rahmen hinaus eröffnet.

Gemäß einer weiteren bevorzugten Ausführungsform wird die Halbleiterlaserdiode mit einer Passivierung am Rand des Wellenleitersteges und über der Lateralstruktur versehen. Die Passivierungsschicht besteht bevorzugt aus einer Oxidschicht oder einer Nitridschicht und besitzt bevorzugt eine Dicke von wenigen hundert Nanometern. Besonders bevorzugt ist es vorgesehen, dass die Oxidschicht aus SiO₂ und die Nitridschicht aus Si₃N₄ besteht. Hierzu kann der Wellenleitersteg eine trapezförmige Grundstruktur ausbilden, was in an sich bekannter Weise durch die oben bereits beschriebenen Ätzverfahren erreicht werden kann.

Bevorzugt ist es vorgesehen, dass durch den Materialabtrag entfernte Volumina der Materialschichtfolge oder der Mehrschichtstruktur in den Materialabtragsbereichen lateral zum Wellenleitersteg bis zu einer Höhe des Wellenleiterstegs mit Benzocyclobuten aufgefüllt sind, so dass eine planare Gesamtoberfläche der Halbleiterlaserdiode besteht.

Gemäß einer weiteren bevorzugten Ausführungsform der Erfindung ist es vorgesehen, dass eine Gesamtoberfläche der Halbleiterlaserdiode mittels Benzocyclobuten bis auf eine Höhe des Wellenleiterstegs planarisiert ist. Das Aufbringen des BCBs erfolgt bevorzugt durch Auftropfen einer geringen Menge flüssigen BCBs. Aufgrund seiner flüssigen Phase bildet das BCB einen gleichmäßigen Film auf der Oberfläche der Halbleiterlaserdiode, der sowohl den Wellenleitersteg als auch die lateral seitlich des Wellenleiterstegs befindlichen Oberflächen zunächst vollständig bedeckt. Durch schnelle Rotation der Halbleiterlaserdiode mit dem darauf aufgebrachten flüssigen BCB kann derjenige Anteil des Films vorteilhaft abgeschleudert werden, der sich oberhalb des Rückens des Wellenleiterstegs befindet. Somit wird bereits in der Flüssigphase des BCBs auf sehr einfache Weise eine im Wesentlichen planare Gesamtoberfläche der Halbleiterlaserdiode erzeugt. Nach der Rotation und dem daraus resultierenden Abschleudern des BCBs kann das BCB dann ausgebacken werden. Ggf. kann noch ein Materialabtrag des BCBs erfolgen, z.B. durch einen physikalischen Ätzprozess, um überschüssiges BCB zu entfernen und die erste Kontaktfläche weiter freizulegen.

Gemäß einer weiteren bevorzugten Ausführungsform der Erfindung ist es vorgesehen, dass die Halbleiterlaserdiode eine erste metallische Kontaktfläche und eine zweite metallische Kontaktfläche umfasst, wobei die erste Kontaktfläche zumindest den Wellenleitersteg mindestens teilweise bedeckt und wobei die zweite Kontaktfläche eine Unterseite der Halbleiterlaserdiode vollständig bedeckt. Die erste und die zweite metallische Kontaktfläche dienen dabei jeweils der verbesserten elektrischen Kontaktierung der Halbleiterlaserdiode. Da die unterhalb der ersten Kontaktfläche aufgebrachte Oxidschicht bzw. Nitridschicht bzw. BCB-Schicht einen sehr guten elektrischen Isolator darstellt, kann die erste Kontaktfläche auch vergleichsweise großflächig und insbesondere über den Bereich der Wellenleiterstege hinausgehend aufgebracht werden, ohne dadurch das Auftreten von Leckströmen übermäßig zu fördern, welche abseits der Wellenleiterstege in das Halbleitersubstrat eindringen würden. Lediglich äußere Randbereiche der Oberfläche der Halbleiterlaserdiode bleiben vorteilhaft in jedem Fall frei von der ersten Kontaktfläche, um einen späteren mechanischen Spaltprozess bzw. Vereinzelungsprozess durch die metallischen Eigenschaften der ersten Kontaktfläche nicht zu erschweren. Eine Geometrie der ersten Kontaktfläche kann dabei z.B. durch einen entsprechenden Maskierungsprozess vorgegeben werden.

Die erste Kontaktfläche stellt bevorzugt den p-Kontakt der Halbleiterlaserdiode dar.

Vorteilhafterweise wird das Halbleitersubstrat vor dem Aufbringen der zweiten Kontaktfläche abgedünnt, z.B. mittels mechanischen Schleifens, um den elektrischen Widerstand des Halbleitersubstrats zu reduzieren und einen späteren Spaltprozess zu vereinfachen. Im Gegensatz zur ersten Kontaktfläche ist die zweite Kontaktfläche bevorzugt vollflächig aufgebracht, ohne das Zurückgreifen auf eine bestimmte Kontaktgeometrie und einen Maskierungsprozess erforderlich zu machen.

Die zweite Kontaktfläche stellt bevorzugt den n-Kontakt der Halbleiterlaserdiode dar.

Bevorzugt ist es vorgesehen, dass die erste Kontaktfläche und/oder die zweite Kontaktfläche aus Aluminium (Au) oder einer Aluminium enthaltenden Legierung oder einer mindestens eine Aluminium-Schicht umfassenden Schichtfolge besteht. Aluminium oder Aluminium enthaltende Legierungen bzw. entsprechende Schichtfolgen stellen vergleichsweise gute elektrische Leiter dar und lassen sich außerdem vergleichsweise einfach, z.B. durch einen Sputter-Prozess, aufbringen.

Bevorzugt enthält die Aluminium enthaltende Legierung zusätzlich Platin (Pt) und/oder Titan (Ti) und/oder umfasst die Schichtfolge zusätzlich mindestens eine Platin-Schicht bzw. eine Titan-Schicht.

Bevorzugt ist es vorgesehen, dass die erste Kontaktfläche und/oder die zweite Kontaktfläche mittels Galvanisierens aufgedickt wird/ist. Durch das Galvanisieren wird die erste bzw. zweite Kontaktfläche also weiter aufgedickt, so dass sich die elektrische Leitfähigkeit ebenso wie die mechanische Stabilität der ersten bzw. zweiten Kontaktfläche verbessern. Die Galvanisierung führt zu einem vergleichsweise schnelleren Schichtwachstum als ein Sputter-Prozess, weshalb die Aufdickung der ersten bzw. zweiten Kontaktfläche nach dem Erreichen einer für die Galvanisierung ausreichenden Schichtdicke bevorzugt durch Galvanisierung erfolgt. Die erste Kontaktfläche wird dazu vorteilhafterweise mit einer Maske maskiert, welche die aufzudickende Kontaktgeometrie vorgibt. Die zu galvanisierende Kontaktgeometrie weist insbesondere eine mindestens geringfügige Beabstandung zum jeweiligen äußeren Rand der ersten Kontaktfläche auf, d.h. also, dass der mittels des Galvanisierungsprozesses aufgedickte Kontaktbereich in jeder Richtung geringfügig kleiner ist als die zuvor mittels des Sputter-Prozesses erzeugte erste Kontaktfläche. Die zweite Kontaktfläche kann auch vollflächig mittels des Galvanisierungsprozesses aufgedickt werden.

Bevorzugt ist es vorgesehen, dass ausschließlich die erste Kontaktfläche galvanisiert wird, nicht aber die zweite Kontaktfläche.

Die erste bzw. die zweite Kontaktfläche ist nach der Galvanisierung bevorzugt 5 µm bis 15 µm stark. Dies hat sich als besonders geeignet erwiesen. Ohne Galvanisierung hingegen ist die erste bzw. die zweite Kontaktfläche bevorzugt 0,5 µm bis 1 µm stark.

Gemäß einer weiteren bevorzugten Ausführungsform der Erfindung ist es vorgesehen, dass eine Vielzahl von Halbleiterlaserdioden auf einem gemeinsamen Halbleitersubstrat hergestellt wird. Das gemeinsame Halbleitersubstrat stellt dabei bevorzugt eine sog. Wafer-Scheibe oder ein Teilstück einer derartigen Wafer-Scheibe dar. Die Wafer-Scheibe kann in unterschiedlichen Größen ausgebildet sein und mehrere Hundert bis mehrere Tausend der erfindungsgemäßen Halbleiterlaserdioden tragen. Die Vielzahl an Halbleiterlaserdioden wird dabei gleichzeitig hergestellt, indem jeweils entweder die gesamte Wafer-Scheibe oder zumindest ein oder mehrere Teilstücke der Wafer-Scheibe dem beschriebenen Herstellungsverfahren unterworfen werden. Beispielsweise kann das Erzeugen der Materialschichtfolge mittels des Epitaxie-Prozesses für die gesamte Wafer-Scheibe erfolgen, während der Materialabtrag zur Erzeugung des Wellenleiterstegs und die folgenden Verfahrensschritte nur an jeweils einem einzelnen Teilstück der Wafer-Scheibe durchgeführt werden. Ein derartiges Teilstück kann beispielsweise 1 cm x 1 cm groß sein und kann immer noch mehrere Hundert der erfindungsgemäßen Halbleiterlaserdioden aufweisen.

Die einzelnen Halbleiterlaserdioden können dann bevorzugt mittels eines mechanischen Spaltprozesses vereinzelt werden. Der Spaltprozess sieht ein Spalten, d.h. ein mechanisches Brechen, des Halbleitersubstrats mit der darauf angeordneten Materialschichtfolge vorteilhaft entlang von Gitterlinien der Kristallgitterstruktur des Halbleitersubstrats vor. Auch in diesem Zusammenhang ist die erfindungsgemäße Ausgestaltung der Lateralstrukturschicht besonders vorteilhaft, da sich mit dieser auch mechanische Eigenschaften, wie beispielsweise Materialverspannungen, in Bereichen der Mehrschichtstruktur vorgeben oder einstellen lassen, so dass dadurch Sollbruchstellen für den mechanischen Spaltprozess vordefiniert oder besser eingegrenzt werden können.

### Allgemeine Beschreibung der Halbleiterlaserdiode:

Die Halbleiterlaserdiode besteht bevorzugt aus einem Halbleitersubstrat mit einer Halbleiterlaserdiode mit einer darauf befindlichen epitaktischen Materialschichtfolge oder Mehrschichtstruktur, die insbesondere eine aktive Zone oder eine aktive Region umfasst, welche von einer oberen und/oder unteren Mantelschicht umgeben ist, welche wiederum durch obere und/oder untere Wellenleiterschichten eingeschlossen ist. Die aktive Zone oder aktive Region weist bevorzugt einen oder mehrere sogenannte Quantenfilme auf. Ebenfalls bevorzugt umfasst die aktive Zone eine oder mehrere Schichten, die sogenannte Quantenpunkte aufweisen. Das Halbleitersubstrat umfasst bevorzugt ein III/V-Halbleitermaterial. Abhängig von dem Zielwellenlängenbereich der Halbleiterlaserdiode ist das Halbleitersubstrat insbesondere GaN, GaAs, InP oder GaSb.

Die Halbleiterlaserdiode besitzt bevorzugt die Geometrie eines Quaders, der so ausgerichtet ist, dass das Halbleitersubstrat unten angeordnet ist und die epitaktische Materialschichtfolge oder Mehrschichtstruktur oben angeordnet ist. Die Oberfläche des Halbleitersubstrats bildet eine Schichtausbreitungsebene für die Mehrschichtstruktur aus. Dieser Quader ist bevorzugt einige hundert bis wenige tausend Mikrometer lang bemessen und wenige hundert Mikrometer breit bemessen. Der Quader ist so ausgerichtet, dass die durch die Breite und Dicke definierten Flächen die Vorder- und Hinterseite der Halbleiterlaserdiode bilden, d.h. dass diese Oberflächen die die Strahlung auskoppelnden Facetten der Halbleiterlaserdiode bilden. An der Oberseite des Quaders ist/sind bevorzugt durch ein Materialabtragungsverfahren ein Wellenleitersteg oder mehrere Wellenleiterstege ausgebildet. Der Wellenleitersteg ist bevorzugt so strukturiert, dass er senkrecht auf der Vorderseite und senkrecht auf der Rückseite der Halbleiterlaserdiode angeordnet ist und dass dessen Querschnitt mit einer Breite von wenigen Mikrometern und einer Höhe von einigen hundert Nanometern bis wenigen Mikrometern bemessen ist. Im Falle einer Ausführung der Erfindung mit mehreren Wellenleiterstegen ist der Abstand der Wellenleiterstege bevorzugt wenige Mikrometer bemessen.

Auf der durch das Materialabtragungsverfahren entstehenden Oberfläche seitlich des Wellenleitersteges ist erfindungsgemäß eine für die Anforderungen an die Halbleiterlaserdiode optimierte Lateralstrukturschicht angeordnet. Diese Lateralstruktur wird bevorzugt durch eine binärwertige Funktion f(x,y) der Position auf der entstandenen Oberfläche, d.h. eine Funktion f, die den Koordinaten (x,y) auf der entstandenen Oberfläche die Werte 0 oder 1 zuweist, beschrieben. Hierbei kann beispielsweise das Koordinatensystem so ausgerichtet sein, dass die Koordinate x den Abstand von der linken Kante des ersten, d.h. des linken von der Vorderseite der Halbleiterlaserdiode gesehenen, Wellenleitersteges parallel zur Facette der Halbleiterlaserdiode gemessen angibt, und dass die Koordinate y den Abstand von der vorderen Facette der Halbleiterlaserdiode senkrecht zu dieser Facette gemessen angibt.

Die Lateralstrukturschicht wird bevorzugt durch Aufbringen eines Materials, z.B. Chrom, mit einem vom umgebenden Halbleiter unterschiedlichen Brechungsindex und Absorptionskoeffizienten an den Stellen, an denen die Funktion f den Wert 1 annimmt, wobei kein Material an den Stellen aufgebracht wird, an denen die Funktion f den Wert 0 annimmt, gebildet. Die Dicke der Lateralstrukturschicht ist bevorzugt mit einigen 10 Nanometern bemessen.

Ebenfalls bevorzugt ist die Erzeugung der Lateralstrukturschicht durch Abtragen von Material an den Stellen der Oberfläche, an denen die Funktion f den Wert 1 annimmt, wobei kein Material an den Stellen, an denen die Funktion f den Wert 0 annimmt, abgetragen wird. Die Tiefe der Lateralstrukturschicht ist bevorzugt mit einigen 10 Nanometern bemessen.

Die Funktion f ist bevorzugt so gewählt, dass die durch sie bestimmte Lateralstruktur die Eigenschaften der Halbleiterlaserdiode optimal beeinflusst. Zu dieser Optimierung wird auch das Material der Lateralstrukturschicht bzw. die Herstellung der Lateralstrukturschicht durch Abtragen von Halbleitermaterial ausgewählt und das nachfolgend beschriebene Passivierungsmaterial ausgewählt, so dass die Funktion f die Halbleiterlaserdiode optimal an die Anwendungsanforderungen anpassen kann.

Der Optimierungsprozess berücksichtigt insbesondere (1) den Einfluss des Brechungsindexverlaufes auf die Lichtmoden in der Halbleiterlaserdiode, (2) die Absorption des Lateralstrukturschichtmaterials für die Lichtmoden in der Halbleiterlaserdiode, (3) die Verspannung des Halbleitermaterials, die durch das Aufbringen des Lateralstrukturschichtmaterials entsteht, und (4) die Veränderung der thermischen Eigenschaften der Halbleiterlaserdiode, insbesondere die Modifikation des Abstimmungsverhaltens durch Aufbringen des Lateralstrukturschichtmaterials.

Der Optimierung der Lateralstruktur, welche die simulierte Vorstufe der erzeugten oder der zu erzeugenden Lateralstrukturschicht bildet, liegt zu Grunde, dass die Strukturierung der Lateralstrukturschicht die physikalischen Eigenschaften der Lateralstrukturschicht beeinflusst und damit die physikalischen Eigenschaften der Halbleiterlaserdiode gezielt verändert werden, was wiederum die Betriebseigenschaften der Halbleiterlaserdiode beeinflusst. Dabei werden in dem Optimierungsverfahren die Eigenschaften und das Verhalten der Halbleiterlaserdiode simuliert und die Veränderung dieser Eigenschaften und des Verhaltens bei einer Anpassung der ebenfalls simulierten Lateralstruktur berücksichtigt, um so nach Abschluss des Optimierungsverfahrens eine entsprechende optimierte tatsächliche Halbleiterlaserdiode herzustellen, bei der die Eigenschaften dadurch optimiert sind, dass eine Lateralstrukturschicht gemäß der vorab optimiert simulierten Lateralstruktur aufgebracht ist.

Bei der Optimierung der Lateralstruktur stellt sich heraus, dass die ersten 500 Nanometer neben dem Wellenleitersteg entscheidend sind für die Wellenlängenabhängigkeit der Absorption und die Wellenlängenabhängigkeit des effektiven Brechungsindex von lateralen Grundmoden, d.h. Moden, die nicht in Lateralrichtung angeregt sind, wogegen weiter vom Wellenleitersteg entfernte Lateralstrukturen keinen messbaren Einfluss auf den effektiven Brechungsindex und die Absorption der lateralen Grundmoden haben. Deswegen wird vorgesehen, dass die Lateralstrukturschicht einen ersten Bereich umfasst, der auf den ersten 500 Nanometern neben dem Wellenleitersteg ausgebildet ist und der bevorzugt zumindest abschnittsweise eine periodische gitterähnliche Struktur aufweist, wobei besonders bevorzugt eben auch andere Abschnitte vorgesehen oder ausgebildet sind, die von einer klassischen Gitterstruktur abweichen.

Weiter haben die auf die ersten 500 Nanometer folgenden Mikrometer einen vergleichbar großen Einfluss auf die Verspannungen des Halbleitermaterials wie die ersten 500 Nanometer. Folglich ist vorgesehen, dass die Lateralstrukturschicht einen zweiten Bereich umfasst, der auf die ersten 500 Nanometer neben dem Wellenleitersteg folgt und bevorzugt etwa eine Breite von 500 Nanometern aufweist, wobei der zweite Bereich beispielsweise eine kammartige Struktur aufweist.

Des Weiteren ist der Einfluss der Lateralstrukturschicht auf die thermischen Eigenschaften der Halbleiterlaserdiode auch durch noch weiter vom Wellenleitersteg entfernte Lateralstrukturen möglich. Dementsprechend umfasst die Lateralstrukturschicht bevorzugt einen dritten Bereich, der sich an den ersten und/oder zweiten Bereich anschließt und bevorzugt ebenfalls eine Breite von etwa 500 Nanometern umfasst.

Damit lassen sich die Einstellung des effektiven Brechungsindex und der Absorption sowie die Verspannung des Halbleitermaterials und die thermischen Eigenschaften nahezu unabhängig optimieren. Der Brechungsindexverlauf beeinflusst entscheidend die Wellenlängenabhängigkeit der Spiegelverluste der Lichtmoden in der Halbleiterlaserdiode, und die ortsabhängige Modulation des Absorptionskoeffizienten beeinflusst entscheidend die internen Verluste der Lichtmoden. Durch diese Effekte kann gezielt die Lichtmode eingestellt werden, die von der Halbleiterlaserdiode besonders stark verstärkt wird, und somit ein hohes Seitenmodenunterdrückungsverhältnis erreicht werden. Aus der Anwendung der Bloch-Theorie auf die Lichtmodengleichung im Halbleiter stellt sich heraus, dass die sog. Übergitterstruktur und sog. Gitter höherer Ordnung, sowie die Überlagerung mehrerer Übergitter, dazu genutzt werden können, um eine hohe Seitenmodenunterdrückung zu erreichen.

Die Verspannung des Halbleitermaterials hat neben dem Spalten von größeren Halbleitermaterialblöcken (Wafern) einen entscheidenden Einfluss auf die energetischen Abstände der Energiebänder, insbesondere zwischen Valenz- und Leitungsband. Dementsprechend führt die lokale Verspannung des Halbleitermaterials in der aktiven Zone zu einer Veränderung des lokalen Verstärkungsprofils und in den übrigen Schichten zu einer Veränderung des Absorptionsprofils der Halbleiterlaserdiode. Somit hat die gezielte Einstellung der lokalen Verspannung einen Einfluss darauf, welcher Teil der Ladungsträger zur Verstärkung der Lichtmode beiträgt, da eine Lichtmode die Emission von Photonen aus den Zuständen besonders effizient stimuliert, mit denen ihr elektromagnetisches Feld einen besonders großen Wirkungsquerschnitt hat. Damit hat die Verspannung des Halbleitermaterials einen Einfluss auf die Effizienz und den Schwellstrom der Halbleiterlaserdiode. Diese beiden Charakteristika der Halbleiterlaserdiode können daher durch gezieltes Einstellen der Verspannung des Halbleitermaterials optimiert werden.

Ein weiteres sehr wichtiges Charakteristikum einer Halbleiterlaserdiode ist ihr Abstimmungsverhalten, d.h. die Tatsache, dass man durch Einstellen der Betriebstemperatur und des Betriebsstroms der Halbleiterlaserdiode ihre Lichtleistung und die emittierte Wellenlänge abstimmen kann. Insbesondere ist es erstrebenswert, einen besonders einfachen, linearen, Zusammenhang zwischen den Betriebsparametern Temperatur und Strom und den Ausgangsparametern Wellenlänge und Leistung zu erreichen, so dass das Abstimmungsverhalten komplett durch zwei Proportionalitätskonstanten, den sog. Tuningparametern, beschrieben werden kann. Die Thermik der Halbleiterlaserdiode hat einen entscheidenden Einfluss auf diese Tuningparameter. Daher kann durch Optimierung der Thermik der Lateralstruktur ein positiver Effekt für das Tuningverhalten der Halbleiterlaserdiode erreicht werden.

Ein wichtiger Aspekt von Halbleiterlaserdioden mit mehr als einem Wellenleitersteg ist die gezielte Kontrolle des Lateralmodenspektrums, d.h. des Spektrums der Moden, die entlang der Richtung der Wellenleiter die gleiche Struktur aufweisen, aber eine unterschiedliche laterale Struktur aufweisen. Unterschiedliche Lateralmoden können durch gezielte Strukturierung des Brechungsindex zwischen den Wellenleiterstegen gezielt unterschiedliche Spiegelverluste erfahren und durch gezielte Strukturierung des Absorptionskoeffizienten zwischen den Wellenleiterstegen unterschiedliche interne Verluste erfahren. Dadurch kann man durch gezielte Wahl der Funktion f die von der Halbleiterlaserdiode verstärkten Lateralmoden einstellen. Dementsprechend kann bei Halbleiterlaserdioden mit mehr als einem Wellenleitersteg ein weiterer Bereich der Lateralstruktur und/oder der Lateralstrukturschicht vorgesehen sein, der die oben genannte Wahl oder Optimierung ermöglicht.

Das Fernfeld der Halbleiterlaserdiode wird durch das elektromagnetische Feld der Lichtmode an der vorderen Facette bestimmt. Diese wiederum wird durch den effektiven Brechungsindex in der Nähe der Facette bestimmt, in den der Einfluss der Lateralstruktur eingeht. Um einen unerwünschten Effekt der Lateralstruktur auf das Fernfeld zu verringern, ist es daher möglich, die Lateralstruktur in der Nähe der Facette zu optimieren. Dies kann im Rahmen der Optimierung des ersten Bereichs erfolgen. Es kann aber auch ein weiterer separater Bereich dazu vorgesehen und ggf. separat optimiert werden.

Der Vorteil durch die vorliegende Erfindung gegenüber dem Stand der Technik ist, dass durch eine gezielte Wahl der Funktion f mehr als eine der hier genannten Eigenschaften der Halbleiterlaserdiode gezielt eingestellt werden kann. Dies führt zu einer effizienteren Planung und damit zu einer Reduktion von Entwicklungskosten für Halbleiterlaserdioden mit gewünschten Charakteristika.

Die erfindungsgemäße Halbleiterlaserdiode besitzt bevorzugt eine Passivierung am Rand des Wellenleitersteges und über der Lateralstruktur. Diese besteht bevorzugt aus einer Oxidschicht oder einer Nitridschicht mit einer Dicke von wenigen hundert Nanometern. Zudem besitzt die erfindungsgemäße Halbleiterlaserdiode einen metallischen Kontakt an der Unterseite und einen metallischen Kontakt an der Oberseite, um so eine bessere elektrische Kontaktierung der Halbleiterlaserdiode zu ermöglichen.

Die vorliegende Erfindung umfasst auch ein Verfahren, bei dem eine Vielzahl von Halbleiterlasern auf einem gemeinsamen Halbleitersubstrat gemäß dem Herstellungsverfahren der oben beschriebenen Ausführungsformen ausgebildet wird und eine sich an die Herstellung anschließende Vereinzelung der Halbleiterlaser, insbesondere eine mechanische Spaltung und/oder ein Sägen, erfolgt.

Nachfolgend wird die Erfindung anhand von in den Figuren dargestellten Ausführungsformen beispielhaft erläutert.

Es zeigen:
- Fig. 1:: eine schematische Ansicht einer Ausführungsform einer erfindungsgemäßen Halbleiterlaserdiode, in der die Ausrichtung der Lateralflächen und die Ausrichtung des Koordinatensystems einer beispielhaften Lateralstrukturschicht angezeigt werden,
- Fig. 2:: eine schematische Draufsicht einer möglichen Ausführungsform einer erfindungsgemäßen Halbleiterlaserdiode mit der Lateralstrukturschicht und einem Wellenleitersteg,
- Fig. 3:: eine schematische Draufsicht einer weiteren möglichen Ausführungsform einer erfindungsgemäßen Halbleiterlaserdiode mit mehreren Wellenleiterstegen und Lateralstrukturschichten und
- Fig. 4:: ein schematisches Ablaufdiagramm einer möglichen Ausführungsform des erfindungsgemäßen Verfahrens zur Herstellung einer monomodigen Halbleiterlaserdiode.

Gleiche Gegenstände, Funktionseinheiten und vergleichbare Komponenten sind figurenübergreifend mit den gleichen Bezugszeichen bezeichnet. Diese Gegenstände, Funktionseinheiten und vergleichbaren Komponenten sind hinsichtlich ihrer technischen Merkmale identisch ausgeführt, sofern sich aus der Beschreibung nicht explizit oder implizit etwas anderes ergibt.

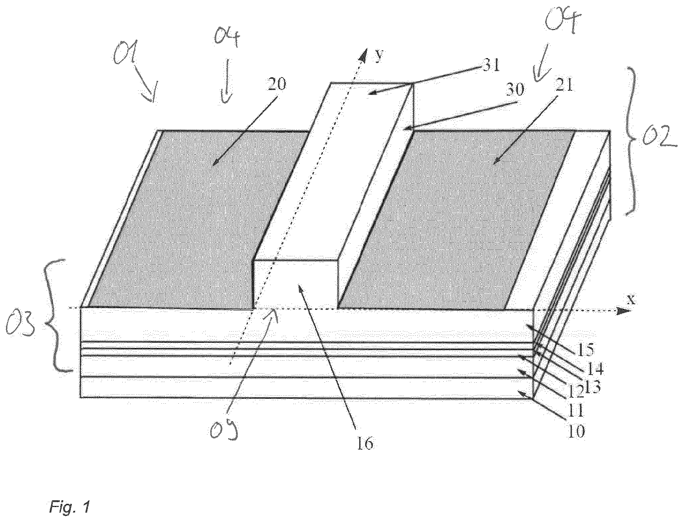

Fig. 1 zeigt beispielhaft und schematisch den Grundaufbau einer Ausführungsform des erfindungsgemäßen Halbleiterlasers 01 oder der erfindungsgemäßen Halbleiterlaserdiode. Diese besteht aus einem Halbleitersubstrat 10, auf dem epitaktisch eine für eine Laserdiode taugliche Mehrschichtstruktur 02 umfassend die einzelnen Schichten 11-16 aufgebracht ist. Die Mehrschichtstruktur 02 umfasst eine aktive Zone oder aktive Region 13, die von einer oberen und unteren Mantelschicht 12, 14 umgeben ist, welche wiederum eine obere und untere Wellenleiterschicht 03 aufweist, die die einzelnen Schichten 11, 15, 16 umfasst.

Aus den oberen Schichten 15, 16 der Wellenleiterschicht 03 wird durch ein Materialabtragungsverfahren in den Materialabtragsbereichen 04 ein Wellenleitersteg 16 erzeugt. Durch das Materialabtragungsverfahren entstehen zwei Lateralflächen 20, 21 seitlich des Wellenleitersteges 16, sowie zwei Flanken 30 am Wellenleitersteg 16. Die Halbleiterlaserdiode oder der Halbleiterlaser 01 wird mit elektrischen Kontakten über die obere Kontaktfläche 31 am Wellenleiter 16 und einer unteren, in der Darstellung der Fig. 1 nicht gezeigten, Kontaktfläche auf der Unterseite des Substrats 10 mit Strom versorgt.

Die Lateralflächen 20, 21 sind hervorgehoben. Auf die hervorgehobenen Flächen wird die optimierte Lateralstrukturschicht gemäß einer optimierten binären Funktion f(x,y) der Lateralstruktur strukturiert. Die Achsen des Koordinatensystems (x,y) sind als gestrichelte Linien eingezeichnet. Die x=0 Achse wird durch das Zusammenstoßen der Lateralflächen 20, 21 mit der Frontfacette der Halbleiterlaserdiode definiert. Die y=0 Achse wird durch das Zusammenstoßen der linken Lateralfläche 20 mit der linken Flanke des Wellenleitersteges 16 definiert.

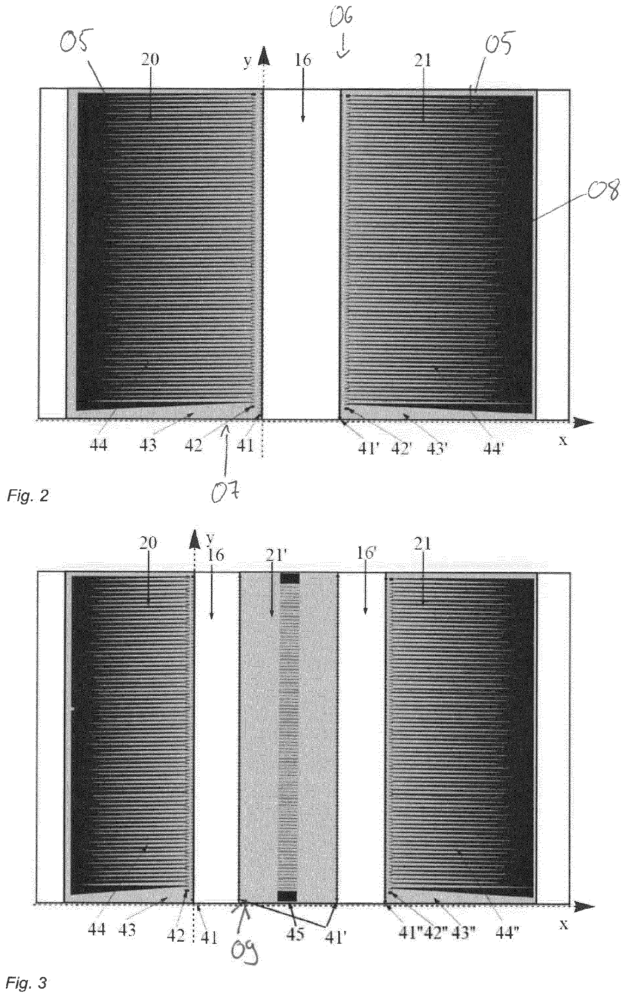

Fig. 2 zeigt beispielhaft und schematisch eine Draufsicht auf eine Lateralstrukturschicht 05, welche gemäß einer optimierten Lateralstruktur für eine Halbleiterlaserdiode ausgebildet wurde und lateral angrenzend zu dem Wellenleitersteg 16 ausgebildet ist. Die Lateralflächen 20, 21 seitlich des Wellenleitersteges 16 sind beispielhaft mit optimierten Strukturelementen 41, 42, 43, 41 sowie 41', 42', 43', 44' der Lateralstrukturschicht 05 ausgestattet. In diesem Beispiel sind die Strukturelemente 41, 41' vorgesehen und in ihrer Form und Anordnung oder Platzierung dazu optimiert, die Wellenleitermode durch periodische Absorption und Modulation des Brechungsindex in der Wellenlänge zu bestimmen. Die Strukturelemente 42, 42' sind beispielweise dazu optimiert, die Materialverspannung in y-Richtung weitgehend zu homogenisieren, und die Strukturelemente 44, 44' sind dazu optimiert, die thermische Stabilität des Abstimmverhaltens der Halbleiterlaserdiode zu gewährleisten.

Die Zonen 43, 43' enthalten keine Strukturelemente, um das Fernfeld der Halbleiterlaserdiode nicht negativ zu beeinflussen. Dies bedeutet, dass die Lateralstruktur f(x,y) in den Zonen 43, 43' den "Wert 0" zugewiesen bekommt und dadurch keine Abscheidung oder Aufbringung von Strukturen der Aluminium enthaltenden Lateralstrukturschicht 05 erfolgt. Die binärwertige Funktion f(x,y) definiert wie im vorhergehenden Ausführungsbeispiel die Strukturelemente 41, 42, 43, 41, 41', 42', 43' und 44' durch die Stellen, an denen sie den Wert 1 annimmt. Damit bildet die Lateralstrukturschicht 05 einzelne Bereiche 06, 07 und 08 aus, die jeweils im Wesentlichen zur Beeinflussung unterschiedlicher Eigenschafen des Halbleiterlasers 01 dienen.

Fig. 3 zeigt beispielhaft und schematisch eine Draufsicht auf eine optimierte Lateralstruktur für eine Halbleiterlaserdiode 01 mit mehreren Wellenleiterstegen16, 16'. Das Beispiel zeigt zwei Wellenleiterstege 16, 16' und drei Zonen der Lateralstruktur 21, 21, 21' mit den optimierten Strukturelementen 41, 42, 43, 41, 41", 42", 43", 44" sowie 41' und 45 der Lateralstrukturschicht 05. Das Koordinatensystem ist analog zu Fig. 1 am linken Wellenleitersteg 16 und an der Frontfacette 09 ausgerichtet. Die Strukturelemente 41, 41' sind im Rahmen der Optimierung der Lateralstruktur dazu optimiert, die Wellenleitermode durch periodische Absorption und Modulation des Brechungsindex in der Wellenlänge zu bestimmen. Die Strukturelemente 42, 42' sind beispielweise dazu optimiert, die Materialverspannung in y-Richtung weitgehend zu homogenisieren, und die Strukturelemente 44, 44' sind dazu optimiert, die thermische Stabilität des Abstimmverhaltens der Halbleiterlaserdiode zu gewährleisten. Die Zonen 43, 43' enthalten keine Strukturelemente, um das Fernfeld der Halbleiterlaserdiode nicht negativ zu beeinflussen. Auch der Halbleiterlaser 01 gemäß Fig. 3 weist damit einzelne Bereiche der Lateralstruktur oder der Lateralstrukturschicht auf.

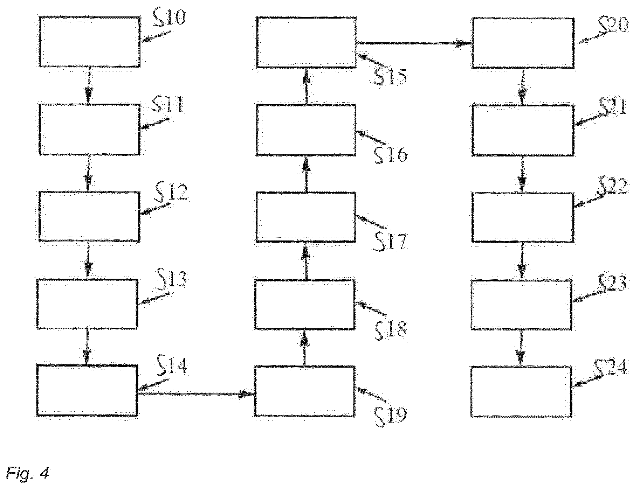

Fig. 4 zeigt beispielhaft eine mögliche Ausführungsform des erfindungsgemäßen Verfahrens zur Herstellung einer monomodigen Halbleiterlaserdiode in Form eines Flussdiagramms oder eines Ablaufdiagramms. Die einzelnen Verfahrensschritte sind vorteilhaft vorgesehen, aber zumindest teilweise nicht zwingend oder nicht zwingend in der beschriebenen Reihenfolge durchzuführen. In einem ersten Verfahrensschritt S10 wird eine Materialschichtfolge oder Mehrschichtstruktur auf einem Halbleitersubstrat mittels Molekularstrahlepitaxie gewachsen. Im darauf folgenden Schritt S11 erfolgt ein Maskierungsprozess zum Maskieren eines Wellenleiterstegs 04 mit einer Ätzmaske.

In Schritt S12 wird ein Materialabtrag des nicht von der Ätzmaske maskierten Bereichs der Materialschichtfolge durchgeführt und so der oder die Materialabtragsbereiche ausgebildet, so dass aus dem nicht abgetragenen Rest der Materialschichtfolge der Wellenleitersteg entsteht.

Im folgenden Schritt S13 wird die diskrete und binäre Funktion f(x,y) als Lateralstruktur und somit als simulierter Vorgänger oder Vorläufer zu der später ausgebildeten oder abgeschiedenen Lateralstrukturschicht erzeugt, dies geschieht durch ein Optimierungsverfahren, welches im Schritt S14 durchlaufen wird, bei dem die Funktion f(x,y) so lange optimiert wird, bis die ebenfalls anhand von Daten betreffend die tatsächliche Halbleiterlaserdiode simulierte und zur Wechselwirkung mit der simulierten Lateralstruktur vorgesehene Halbleiterlaserdiode die gewünschten Eigenschaften in Vorabberechnung oder Simulationen erreicht hat.

In Schritt S15 wird dann ein weiterer Maskierungsprozess durchgeführt, diesmal zur Erzeugung der Lateralstrukturschicht nach Maßgabe der durch die Optimierung vorgegebenen Funktion f(x,y) der Lateralstruktur, wobei die Lateralstrukturelemente der Lateralstrukturschicht überall dort angeordnet werden, wo die binärwertige Funktion f(x,y) den Wert 1 annimmt. Im folgenden Verfahrensschritt S16 wird das metallische Material der Lateralstrukturschicht flächig auf die Materialschichtfolge der Halbleiterlaserdiode mittels Aufdampfen aufgebracht. In Schritt S17 wird nun die Aufdampfmaske mit dem auf der Aufdampfmaske befindlichen Lateralstrukturmaterial entfernt, so dass nur die Lateralstrukturschichtelemente auf der Oberfläche der Materialschichtfolge verbleiben.

Somit wurde in einer beispielhaften Ausführungsform des Verfahrens eine Halbleiterlaserstruktur oder Halbleiterlaserdiode mit einer erfindungsgemäßen Lateralstrukturschicht erzeugt. Auch grundsätzlich andere Verfahrensausführungen sind denkbar und von der vorliegenden Erfindung umfasst, solange das Verfahren die simulierte Optimierung einer zweidimensionalen diskreten binärwertigen Lateralstruktur und die anschließende Ausbildung einer Lateralstrukturschicht zur Optimierung der Eigenschaften des Halbleiterlasers gemäß der optimierten Lateralstruktur aufweist.

Auf der Lateralstrukturschicht wird in Schritt S18 eine BCB-Schicht auf der Oberfläche der Halbleiterlaserdiode angeordnet, indem zunächst flüssiges BCB auf die Oberfläche der Halbleiterlaserdiode aufgebracht wird. Durch Abschleudern des flüssigen BCBs in Schritt S19 wird überschüssiges BCB wieder entfernt, und in Schritt S20 wird die BCB-Schicht ausgebacken. Im folgenden Schritt S21 wird eine erste metallische Kontaktfläche erzeugt und diese anschließend in Schritt S22 zur Aufdickung mit zusätzlichem Material galvanisiert. In Schritt S23 wird das Halbleitersubstrat an seiner Unterseite, also an seiner der ersten Kontaktfläche abgewandten Seite, mittels eines mechanischen Schleifprozesses abgedünnt. Mittels eines weiteren Sputter-Prozesses wird dann die zweite metallische Kontaktfläche in Schritt S24 erzeugt. Damit ist die Herstellung einer beispielhaften Halbleiterlaserdiode abgeschlossen. Auch die Schritte S20 bis S24 können im Rahmen des Fachwissens des Durchschnittsfachmanns variiert, verknüpft und/oder ausgelassen oder angepasst werden, solange diese Kombinationen unter den Gegenstand der Ansprüche fallen.

## Patentansprüche

1. Verfahren zur Herstellung eines Halbleiterlasers (01) umfassend die Verfahrensschritte:
- Aufbringen einer Mehrschichtstruktur (02) auf einem Halbleitersubstrat (10), wobei die Schichten der Mehrschichtstruktur (02) parallel zu einer durch eine Oberfläche des Halbleitersubstrats (10) definierten Schichtausbreitungsebene verlaufen und wobei das Aufbringen der Mehrschichtstruktur (02) zumindest das Erzeugen einer aktiven Region (13) umfasst;
- Abtragen von Material der Mehrschichtstruktur (02) in zumindest zwei voneinander getrennten Materialabtragsbereichen (04), wobei der Materialabtrag im Wesentlichen senkrecht zur Schichtausbreitungsebene erfolgt und dadurch ein Wellenleitersteg (16,16') gebildet wird;
- Erzeugen von einer Isolationsschicht auf zumindest den Materialabtragsbereichen (04);
- Bestimmen einer zweidimensionalen diskreten binären Lateralstruktur (f(x,y)) in einem Optimierungsverfahren unter Berücksichtigung zumindest der gewünschten Eigenschaften der dreidimensionalen Lasermode, insbesondere der Wellenlänge, wobei im Rahmen des Optimierungsverfahrens die Bereiche, in denen eine Lateralstrukturschicht (05) aufbringbar ist, in ein regelmäßiges Gitter unterteilt werden und zur Beschreibung der Lateralstruktur eine die Gitterzellen betreffende zweidimensionale Startfunktion optimiert wird, wobei die Optimierung mindestens zur Einstellung der Zielwellenlänge in einem ersten Bereich, der auf den ersten 500 nm neben dem Wellenleitersteg (16,16') ausgebildet ist, zur Einstellung einer Verspannung in der Mehrschichtstruktur durch Strukturierung in einem sich an den ersten Bereich anschließenden zweiten Bereich und zur gezielten Unterdrückung unerwünschter dreidimensionaler Lasermoden in einem dritten Bereich weiter vom Wellenleitersteg (16, 16') entfernt liegender Strukturen erfolgt, wobei in dem zweiten und dritten Bereich beidseitig vom Wellenleitersteg (16,16') befindliche, an eine vordere Facette (09) angrenzende Zonen (43, 43'') frei von Strukturelementen ausgebildet werden, um das Fernfeld des Halbleiterlasers (01) nicht durch eine Lateralstruktur an dieser vorderen Facette (09) negativ zu beeinflussen;
- Aufbringen von einer Lateralstrukturschicht (05) aus Material, welches einen vom umgebenden Halbleitermaterial unterschiedlichen Brechungsindex aufweist, zumindest im Bereich der Materialabtragsbereiche (04), wobei die Strukturen (41 - 43, 41' - 43') der Lateralstrukturschicht (05) in einem Maskierungs- und Abscheidungsprozess anhand der optimierten Lateralstruktur (f(x,y)) ausgebildet werden.

2. Verfahren nach Anspruch 1,
wobei der zweite Bereich eine Breite von 500 nm aufweist.

3. Verfahren nach Anspruch 1 oder 2,
wobei die Startfunktion des Optimierungsverfahrens eine Reihe, bevorzugt zwei oder mehr Reihen, von parallelen gleichmäßig beabstandeten Stegen darstellt.

4. Verfahren nach einem der Ansprüche 1 bis 3,
wobei im Optimierungsverfahren die binären Werte von bis zu 10⁸, bevorzugt von bis zu 10¹⁰, Gitterzellen ausgehend von den Binärwerten der Startfunktion optimiert werden.

5. Verfahren nach einem der Ansprüche 1 bis 4,
wobei das Optimierungsverfahren die Lateralstruktur (f(x,y)) auch im Hinblick auf die thermischen Eigenschaften und/oder die mechanische Verspannung des Halbleiterlasers (01) optimiert.

6. Verfahren nach einem der Ansprüche 1 bis 5,
wobei das Optimierungsverfahren die Lateralstruktur (f(x,y)) in unterschiedlichen Abstandsbereichen vom Wellenleitersteg optimiert.

7. Verfahren nach einem der Ansprüche 1 bis 6,
wobei eine Vielzahl von Halbleiterlasern (01) benachbart zueinander oder aneinander angrenzend auf einem gemeinsamen Halbleitersubstrat (10) ausgebildet wird und eine an die Herstellung anschließende Vereinzelung der Halbleiterlaser (01), insbesondere eine mechanische Spaltung und/oder ein Sägen, erfolgt.

8. Halbleiterlaser (01) aufweisend
eine Mehrschichtstruktur (02) umfassend zumindest einen Wellenleitersteg (16,16') und an den Wellenleitersteg (16,16') seitlich angrenzende Materialabtragsbereiche (04), wobei die Mehrschichtstruktur (02) auf einem Halbleitersubstrat (10) angeordnet ist und wobei durch eine Oberfläche des Halbleitersubstrats (10) eine Schichtausbreitungsebene (26) definiert wird, wobei die Mehrschichtstruktur (02) senkrecht zur Schichtausbreitungsebene zwischen Halbleitersubstrat und Wellenleitersteg und/oder Materialabtragsbereich (04) zumindest eine aktive Region (13) aufweist, wobei die aktive Region (13) eine Schicht- und Materialstruktur zur Ausbildung einer Laserschicht auf der Grundlage des Prinzips der stimulierten Emission aufweist, wobei der Halbleiterlaser (01) eine vordere, die Emissionsmode auskoppelnde Facette (09) aufweist, wobei zumindest in den Materialabtragsbereichen (04) eine Lateralstrukturschicht (05) vorgesehen ist, wobei die Lateralstrukturschicht (05) in der Schichtausbreitungsebene eine zumindest die Eigenschaften der dreidimensionalen Lasermode optimierende Lateralstruktur (f(x,y)) aufweist, bei der das Material der Lateralstrukturschicht (05), welches einen vom umgebenden Halbleitermaterial unterschiedlichen Brechungsindex aufweist, in einem Teil der Zellen eines regelmäßigen zweidimensionalen Rasters angeordnet ist, **dadurch gekennzeichnet, dass** die Lateralstrukturschicht (05) einen ersten Bereich, der auf den ersten 500 nm neben dem Wellenleitersteg (16,16') ausgebildet ist und zur Einstellung der Zielwellenlänge eingerichtet ist, einen sich an den ersten Bereich anschließenden zweiten Bereich, der zur Einstellung einer Verspannung in der Mehrschichtstruktur eingerichtet ist, und einen weiter vom Wellenleitersteg entfernten dritten Bereich, der zur gezielten Unterdrückung unerwünschter dreidimensionaler Lasermoden eingerichtet ist, umfasst, wobei der zweite und dritte Bereich an die vordere Facette (09) angrenzende Zonen (43, 43") beidseitig vom Wellenleitersteg (16,16') aufweist und wobei die Zonen (43, 43'') frei von Strukturelementen ausgebildet sind.

9. Halbleiterlaser nach Anspruch 8,
wobei
der zweite Bereich eine Breite von 500 nm aufweist.

10. Halbleiterlaser nach Anspruch 8 oder 9,
wobei
die Lateralstrukturschicht (05) eine Schichtdicke von 25 nm bis 70 nm senkrecht zur Schichtausbreitungsebene aufweist.

11. Halbleiterlaser nach einem der Ansprüche 8 bis 10,
wobei
die Lateralstrukturschicht (05) in der Schichtausbreitungsebene durch zusammenhängende Einzelstrukturen gebildet ist, die jeweils eine Grundfläche oder ein Vielfaches einer Grundfläche aufweisen, wobei die Grundfläche dadurch gebildet ist, dass eine zu strukturierende Fläche von weniger als 0,25 mm² in 10⁸ bis 10¹⁰ gleichmäßige Gitterzellen unterteilt wird.

12. Halbleiterlaser nach einem der Ansprüche 8 bis 11,
wobei
das Material der Lateralstrukturschicht (05) Chrom umfasst oder aus Chrom gebildet ist.

13. Halbleiterlaser (01) nach einem der Ansprüche 8 bis 12,
wobei
sich die Lateralstrukturschicht (05) senkrecht zur Ausbreitungs- oder Längsrichtung des Wellenleiterstegs (16, 16') über einen Bereich von bis zu 1,5 µm erstreckt.

14. Halbleiterlaser nach einem der Ansprüche 8 bis 13,
wobei
die Lateralstrukturschicht (05) mehrere Bereiche aufweist, die jeweils zur Optimierung einer Eigenschaft des Halbleiterlasers dienen.

## Claims

1. A method for producing a semiconductor laser (01), the method comprising the following steps:
- applying a multilayer structure (02) on a semiconductor substrate (10), the layers of the multilayer structure (02) extending parallel to a layer expansion plane defined by a surface of the semiconductor substrate (10), and the application of the multilayer structure (02) including at least producing an active region (13).
- removing material of the multilayer structure (02) in at least two separate material removal areas (04), the material removal taking place essentially perpendicular to the layer expansion plane, thus forming a waveguide ridge (16, 16').
- generating an insulation layer on at least the material removal areas (04).
- determining a two-dimensional discrete binary lateral structure (f(x,y)) in an optimization method while taking into consideration at least the desired properties of the three-dimensional laser mode, in particular the wavelength, the areas in which a lateral structural layer (05) is applicable being divided into a uniform grid in the context of the optimization method and a two-dimensional start function pertaining to the grid cells being optimized for describing the lateral structure, the optimization taking place in a first area which is formed on the first 500 nm adjacent to the waveguide ridge (16, 16'), at least for setting the target wavelength, by structurization in a second area bordering the first area for setting a bracing in the multilayer structure and in a third area of structures further away from the waveguide ridge (16, 16') for the targeted suppression of undesired three-dimensional laser modes, zones (43, 43'') located on both sides of the waveguide ridge (16, 16') and bordering a front facet (09) being formed free of structural elements in the second and third areas in order to not negatively influence the far field of the semiconductor laser via a lateral structure on this front facet (09).
- applying a lateral structural layer (05) made of a material which has a refractive index different to that of the surrounding semiconductor material at least in the area of the material removal areas (04), the structures (41 - 43, 41' - 43') of the lateral structural layer (05) being formed in a masking and deposition process based on the optimized lateral structure (f(x,y)).

2. The method according to claim 1
wherein the second area has a width of 500 nm.

3. The method according to claim 1 or 2,
wherein the start function of the optimization method represents a row, preferably two or more rows, of parallel, evenly spaced ridges.

4. The method according to any one of claims 1 to 3,
wherein the binary values of up to 10⁸, preferably up to 10¹⁰, grid cells are optimized in the optimization method, starting from the binary values of the start function.

5. The method according to any one of the claims 1 to 4,
wherein the optimization method optimizes the lateral structure (f(x,y)) also with regard to the thermal properties and/or the mechanical bracing of the semiconductor laser (01).

6. The method according to any one of the claims 1 to 5,
wherein the optimization method optimizes the lateral structure (f(x,y)) in different distance ranges of the waveguide ridge.

7. The method according to any one of the claims 1 to 6,
wherein a plurality of semiconductor lasers (01) are formed adjacent to each other or bordering each other on a shared semiconductor substrate (10) and a separation of the semiconductor lasers (01), in particular a mechanical splitting and/or sawing, takes place after the production.

8. A semiconductor laser (01), comprising
a multilayer structure (02) comprising at least one waveguide ridge (16, 16') and material removal areas (04) laterally bordering the waveguide ridge (16, 16'), the multilayer structure (02) being disposed on a semiconductor substrate (10) and a layer expansion plane (26) being defined by a surface of the semiconductor substrate (10), the multilayer structure (02) having at least one active region (13) located perpendicular to the layer expansion plane between the semiconductor substrate and the waveguide ridge and/or the material removal area (04), the active region (13) having a layer structure and material structure for forming a laser layer based on the principle of the stimulated emission, the semiconductor laser (01) having a front facet (09) decoupling the emission mode, a lateral structural layer (05) being provided at least in the material removal areas (04), the lateral structural layer (05) having a lateral structure (f(x,y)) in the layer expansion plane, the lateral structure (f(x,y)) optimizing at least the properties of the three-dimensional laser mode and the material of the lateral structure layer (05), which has a refractive index different to that of the surrounding semiconductor material, being disposed in a part of the cells of a uniform two-dimensional grid, **characterized in that** the lateral structural layer (05) comprises a first area which is formed on the first 500 nm adjacent to the waveguide ridge (16, 16') and is configured for setting the target wavelength and a second area which borders the first area and is configured for setting a bracing in the multilayer structure and a third area which is disposed further away from the waveguide ridge and is configured for the targeted suppression of undesired three-dimensional laser modes, the second and third areas having zones (43, 43'') bordering the front facet (09) and disposed on both sides of the waveguide ridge (16, 16') and the zones (43, 43'') being formed free of structural elements.

9. The semiconductor laser according to claim 8,
wherein the second area has a width of 500 nm.

10. The semiconductor laser according to claim 8 or 9,
wherein the lateral structural layer (05) has a layer thickness of 25 nm to 70 nm perpendicular to the layer expansion plane.

11. The semiconductor laser according to any one of claims 8 to 10, wherein the lateral structural layer (05) is formed in the layer expansion plane by contiguous individual structures, which each have a base surface or a multiple of a base surface, the base surface being formed by a surface of less than 0.25 mm² to be structured being divided into 10⁸ to 10¹⁰ even grid cells.

12. The semiconductor laser according to any one of the claims 8 to 11,
wherein the material of the lateral structural layer (05) comprises chrome or is made of chrome.

13. The semiconductor laser (01) according to any one of the claims 8 to 12,
wherein the lateral structural layer (05) extends across an area of up to 1.5 µm perpendicular to the expansion or length of the waveguide ridge (16, 16').

14. The semiconductor laser according to any one of the claims 8 to 13,
wherein the lateral structural layer (05) has several areas which each serve to optimize a property of the semiconductor laser.

## Revendications

1. Procédé de fabrication d'un laser à semi-conducteur (01), comprenant les étapes suivantes :
- appliquer une structure (02) multicouche sur un substrat (10) semi-conducteur, les couches de la structure (02) multicouche s'étendant parallèlement à un plan d'expansion de couche défini par une surface du substrat (10) semi-conducteur, et l'application de la structure (02) multicouche comprenant au moins la production d'une région (13) active ;
- enlever du matériau de la structure (02) multicouche dans au moins deux sections (04) d'enlèvement de matériau séparées, l'enlèvement de matériau s'effectuant essentiellement perpendiculairement au plan d'expansion de couche, formant ainsi un guide d'ondes à nervure (16, 16').
- générer une couche d'isolation sur au moins les sections (04) d'enlèvement de matériau ;
- déterminer une structure (f(x,y)) latérale binaire discrète bidimensionnelle dans un procédé d'optimisation tout en prenant en considération au moins les propriétés souhaitées du mode laser tridimensionnel, en particulier la longueur d'onde, les sections dans lesquelles une couche de structure (05) latérale est applicable étant divisées en une grille uniforme dans le cadre du procédé d'optimisation et une fonction de démarrage bidimensionnelle se rapportant aux cellules de grille étant optimisée pour décrire la structure latérale, l'optimisation ayant lieu dans une première section qui est formée sur les premiers 500 nm adjacents au guide d'ondes à nervure (16, 16') au moins pour fixer la longueur d'onde cible et par structuration dans une deuxième section adjacente pour fixer un contreventement dans la structure multicouche et dans une troisième section de structure plus éloignée du guide d'ondes à nervure (16, 16') pour la suppression ciblée de modes laser tridimensionnels indésirables, des zones (43, 43'') situées de part et d'autre du guide d'ondes à nervure (16, 16') et bordant une facette (09) frontale étant formées de manière à être dépourvues d'éléments de structure dans les deuxième et la troisième sections afin de ne pas influencer négativement le champ lointain du laser à semi-conducteur par l'intermédiaire d'une structure latérale sur cette facette frontale (09) ;
- appliquer une couche de structure (05) latérale faite d'un matériau qui a un indice de réfraction différent de celui du matériau à semi-conducteur environnant au moins dans la section des sections (04) d'enlèvement de matériau, les structures (41 - 43, 41' - 43') de la couche de structure (05) latérale étant formées dans un processus de masquage et de dépôt basé sur la structure (f(x,y)) latérale optimisée.

2. Procédé selon la revendication 1,
dans lequel la deuxième section a une largeur de 500 nm.

3. Procédé selon la revendication 1 ou la revendication 2,
dans lequel la fonction de démarrage du procédé d'optimisation représente une ligne, de préférence deux lignes ou plus, des nervures parallèles et régulièrement espacées.

4. Procédé selon l'une quelconque des revendications 1 à 3,
dans lequel les valeurs binaires de jusqu'à 10⁸, de préférence jusqu'à 10¹⁰, cellules de grille sont optimisées dans le procédé d'optimisation, à partir des valeurs binaires de la fonction de démarrage.

5. Procédé selon l'une quelconque des revendications 1 à 4,
dans lequel le procédé d'optimisation optimise la structure (f(x,y)) latérale également en ce qui concerne les propriétés thermiques et/ou le contreventement mécanique du laser à semi-conducteur (01).

6. Procédé selon l'une quelconque des revendications 1 à 5,
dans lequel le procédé d'optimisation optimise la structure (f(x,y)) latérale dans différentes plages de distance du guide d'ondes à nervure.

7. Procédé selon l'une quelconque des revendications 1 à 6,
dans lequel une pluralité de lasers à semi-conducteur (01) est formée de manière à être adjacents les uns aux autres ou les uns bordant les autres sur un substrat (10) semi-conducteur partagé et une séparation des lasers à semi-conducteur (01), en particulier une division mécanique et/ou un sciage, a lieu après la production.

8. Laser à semi-conducteur (01), comprenant
une structure (02) multicouche comprenant au moins un guide d'ondes à nervure (16, 16') et des sections (04) d'enlèvement de matériau bordant latéralement le guide d'ondes à nervure (16, 16'), la structure (02) multicouche étant disposée sur un substrat (10) semi-conducteur et un plan (26) d'expansion de couche étant défini par une surface du substrat (10) semi-conducteur, la structure (02) multicouche ayant au moins une région (13) active située perpendiculairement au plan d'expansion de couche entre le substrat semi-conducteur et le guide d'ondes à nervure et/ou la section (04) d'enlèvement de matériau, la région (13) active ayant une structure de couche et de matériau pour former une couche laser basée sur le principe de l'émission stimulée, le laser à semi-conducteur (01) ayant une facette frontale (09) découplant le mode d'émission, une couche de structure (05) latérale étant prévue au moins dans les sections (04) d'enlèvement de matériau, la couche de structure (05) latérale ayant une structure (f(x,y)) latérale dans le plan d'expansion de couche, la structure (f(x,y)) latérale optimisant au moins les propriétés du mode laser tridimensionnel et le matériau de la couche de structure latérale (05), qui a un indice de réfraction différent de celui du matériau à semi-conducteur environnant, étant disposé dans une partie des cellules d'une grille bidimensionnelle uniforme dans la structure (f(x,y)) latérale, **caractérisé en ce que** la couche de structure (05) latérale comprend une première section qui est formée sur les premiers 500 nm adjacents au guide d'ondes à nervure (16, 16') et est configurée pour fixer la longueur d'onde cible, une deuxième section qui borde la première section et est configurée pour fixer un contreventement dans la structure multicouche et une troisième section qui est disposée plus éloigné du guide d'ondes à nervure et est configurée pour la suppression ciblée de modes laser tridimensionnels indésirables, les deuxième et troisième sections ayant des zones (43, 43'') bordant la facette (09) frontale et disposées de part et d'autre du guide d'ondes à nervure (16, 16') et les zones (43, 43'') étant formées de manière à être dépourvues d'éléments de structure.

9. Laser à semi-conducteur selon la revendication 8,
dans lequel la deuxième section a une largeur de 500 nm.

10. Laser à semi-conducteur selon la revendication 8 ou la revendication 9,
dans lequel la couche de structure (05) latérale a une épaisseur de couche de 25 nm à 70 nm perpendiculairement au plan d'expansion de couche.

11. Laser à semi-conducteur selon l'une quelconque des revendications 8 à 10,
dans lequel la couche de structure (05) latérale est formée dans le plan d'expansion de couche par des structures individuelles contiguës, qui ont chacune une surface de base ou un multiple d'une surface de base, la surface de base étant formée par une surface à structurer de moins de 0,25 mm² divisée en 10⁸ à 10¹⁰ cellules de grille égales.

12. Laser à semi-conducteur selon l'une quelconque des revendications 8 à 11,
dans lequel le matériau de la couche de structure (05) latérale comprend du chrome ou est constitué de chrome.

13. Laser à semi-conducteur (01) selon l'une quelconque des revendications 8 à 12,
dans lequel la couche de structure (05) latérale s'étend sur une section allant jusqu'à 1,5 µm perpendiculairement à la direction de l'expansion ou à la longueur du guide d'ondes à nervure (16, 16').

14. Laser à semi-conducteur selon l'une quelconque des revendications 8 à 13,
dans lequel la couche de structure (05) latérale a plusieurs sections qui servent chacune à optimiser une propriété du laser à semi-conducteur.
